# EUROPEAN PATENT APPLICATION

(11) **EP 3 826 437 A1**
(43) Date of publication of application: **26.05.2021**
(21) Application number: 19838570.0
(22) Date of filing: 17.07.2019
(51) Int. Cl.: H05K 1/05, B32B 15/08, H01B 5/14, H01L 23/12, H01L 23/14

(54) **METAL BASE SUBSTRATE**

(30) Priority: 18.07.2018 JP 2018134788
(71) Applicant: Mitsubishi Materials Corporation, Tokyo 100-8117 (JP)
(72) Inventor: ISHIKAWA Fumiaki, Naka-shi, Ibaraki 311-0102 (JP); NONAKA Sohei, Naka-shi, Ibaraki 311-0102 (JP)
(74) Representative: Hoffmann Eitle
(86) International application number: PCT/JP2019/028057
(87) International publication number: WO 2020/017543

(57) **Abstract**

A metal base substrate (2) including: a metal base (10); an insulation layer (20); and a circuit layer (40), the metal base (10), the insulation layer (20) and the circuit layer (40) being laminated in an order, wherein the insulation layer (20) includes a resin, a film thickness of the circuit layer (40) is in a range of 10 µm or more and 1000 µm or less, and a yield stress of the circuit layer (40) is in a range of 10 MPa or more and 150 MPa or less.

## Description

### [Technical Field]

The present invention relates to a metal base substrate.

The present application claims priority based on Japanese Patent Application No. 2018-134788 filed in Japan on July 18, 2018, the contents of which are incorporated herein by reference.

### [Background Art]

A metal base substrate is known as one of the substrates for mounting an electronic component such as semiconductor elements. The metal base substrate is a laminate in which a metal substrate, an insulation layer, and a circuit layer are laminated in this order. The electronic component is mounted on the circuit layer via solder. In the metal base substrate having such a configuration, the heat generated in the electronic component is transferred to the metal substrate via the insulation layer and radiated from the metal substrate to the outside.

The insulation layer of the metal base substrate is generally formed of an insulating resin composition containing a resin having excellent insulating properties and ceramic particles (thermally conductive filler) having excellent thermal conductivity. As the resin for the insulation layer, a polyimide resin, a polyamideimide resin, and a silicone resin are used. For example, Patent Literature 1 discloses a metal-clad laminate using a polyimide resin layer containing a thermally conductive filler in the range of 40 to 80 vol% as an insulation layer. Further, in Patent Literature 2, a circuit board, in which the resin forming the insulation layer is a silicone resin composed of a polydimethylsiloxane backbone, the inorganic filler in the insulation layer is 45 to 60% by volume, and 25% by mass or more of the inorganic filler is crystalline silica, is disclosed.

### [Prior Art Literature]

### [Patent Literature]

Patent Literature 1: Japanese Patent No. 5665449 (B)
Patent Literature 2: Japanese Unexamined Patent Application, First Publication No. 2017-152610 (A)

### [Summary of Invention]

### [Technical Problem]

By the way, a metal-clad laminate as described in Patent Literature 1 generally has a large thermal expansion coefficient, and an electronic component usually made of ceramic has a low thermal expansion coefficient. The bigger the difference of the thermal expansion coefficients between the metal-clad laminate and the electronic component, the more cracking of the solder being promoted, since the stress applied to the solder joining the electronic component and the metal base substrate increases because of the cooling/heating cycle due to the on/off of the electronic component and the external environment.

On the other hand, the silicone resin described in Patent Literature 2 has lower elasticity than the polyimide resin and the polyamideimide resin. However, since the insulation layer of the metal base substrate contains a thermally conductive filler, the elasticity of the insulation layer is lower than that of the silicone resin alone. Therefore, it is difficult to sufficiently reduce the stress applied to the solder that joins the electronic component and the metal base substrate by the cooling/heating cycle only by using the silicone resin as the resin for the insulation layer.

The present invention has been made in view of the above-mentioned circumstances, and an object of the present invention is to provide a metal base substrate in which the occurrence of cracking being suppressed even if it is subjected to a cooling/heating cycle in a state where an electronic component is mounted via a solder.

### [Solution to Problem]

In order to solve the above problems, the metal base substrate of the present invention is a metal base substrate including: a metal base; an insulation layer; and a circuit layer, the metal base, the insulation layer and the circuit layer being laminated in an order, wherein the insulation layer includes a resin, a film thickness of the circuit layer is in a range of 10 µm or more and 1000 µm or less, and a yield stress of the circuit layer is in a range of 10 MPa or more and 150 MPa or less.

According to the metal base substrate of the present invention, deformation of the circuit layer is facilitated because the film thickness is in the range of 10 µm or more and 1000 µm or less and the yield stress is in the range of 10 MPa or more and 150 MPa or less. Therefore, when a cooling/heating cycle is applied, the stress applied to the solder can be relaxed by the deformation of the circuit layer, so that the occurrence of cracking of the solder can be suppressed.

Here, in the metal base substrate of the present invention, the yield stress of the circuit layer is preferably 110 MPa or less.

In this case, since the deformation of the circuit layer is further facilitated, the stress applied to the solder can be more reliably relaxed.

Further, in the metal base substrate of the present invention, the circuit layer is preferably made of aluminum.

In this case, since reduction of the yield stress (0.2% proof stress) of aluminum is facilitated by the heat treatment, the effect of suppressing the occurrence of cracking of the solder by the circuit layer can be relatively easily increased by the heat treatment.

### [Advantageous Effects of Invention]

According to the present invention, it is possible to provide a metal base substrate in which the occurrence of cracking being suppressed even if it is subjected to a cooling/heating cycle in a state where an electronic component is mounted via a solder.

### [Brief Description of Drawings]

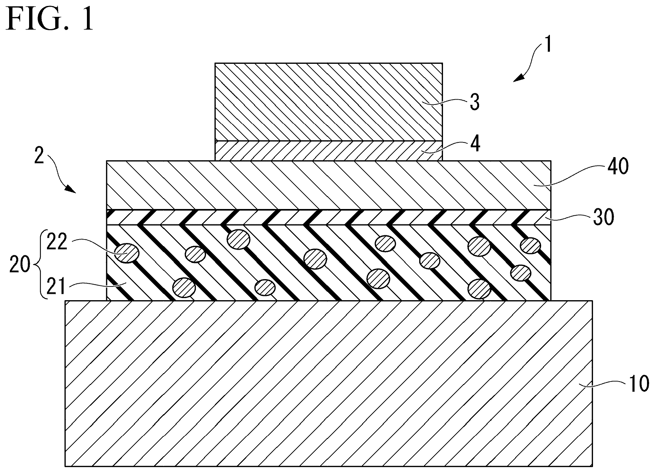

FIG. 1 is a schematic cross-sectional view of a module using a metal base substrate according to an embodiment of the present invention.

### [Description of Embodiments]

The metal base substrate according to the embodiment of the present invention will be described below with reference to the drawings.

FIG. 1 is a schematic cross-sectional view of a module using a metal base substrate according to an embodiment of the present invention.

In FIG. 1, the module 1 includes the metal base substrate 2 and the electronic component 3 mounted on the metal base substrate 2. The metal base substrate 2 is a laminate in which the metal substrate 10, the insulation layer 20, the adhesion layer 30, and the circuit layer 40 are laminated in this order. The circuit layer 40 is formed in a circuit pattern. The electronic component 3 is joined via the solder 4 on the circuit layer 40 formed in the circuit pattern.

The metal substrate 10 is a member that serves as a base for the metal base substrate 2. As the metal substrate 10, a copper plate, an aluminum plate, and a laminated plate thereof can be used.

The insulation layer 20 is a layer for insulating the metal substrate 10 and the circuit layer 40. The insulation layer 20 is formed of an insulating resin composition containing the insulating resin 21 and ceramic particles 22 (thermally conductive filler). By forming the insulation layer 20 from an insulating resin composition containing the insulating resin 21 having a high insulating property and the ceramic particles 22 having a high thermal conductivity, the thermal resistance of the entire metal base substrate 2 from the circuit layer 40 to the metal substrate 10 can be reduced further while maintaining the insulating property thereof.

The insulating resin 21 is preferably a polyimide resin, a polyamideimide resin, or a mixture thereof. Since the polyimide resin and the polyamideimide resin have an imide bond, they have excellent heat resistance and mechanical properties.

As the ceramic particles 22, silica (silicon dioxide) particles, alumina (aluminum oxide) particles, boron nitride (BN) particles, titanium oxide particles, alumina-doped silica particles, alumina hydrate particles, aluminum nitride particles and the like can be used. As the ceramic particles 22, one type may be used alone, or two or more types may be used in combination. Among these ceramic particles, alumina particles are preferable because they have high thermal conductivity. The form of the ceramic particles 22 is not particularly limited, but is preferably agglomerated particles of fine ceramic particles or single crystal ceramic particles.

The agglomerated particles of the fine ceramic particles may be agglomerates in which the primary particles are relatively weakly linked, or may be aggregates in which the primary particles are relatively strongly linked. Further, the aggregated particles may form a particle aggregate in which the aggregated particles are further aggregated. Since the primary particles of the ceramic particles 22 form aggregated particles and are dispersed in the insulation layer 20, a network is formed by mutual contact between the ceramic particles 22, and heat conduction between the primary particles of the ceramic particles 22 is facilitated improving the thermal conductivity of the insulation layer 20.

Commercially available products of aggregated particles of fine ceramic particles include AE50, AE130, AE200, AE300, AE380, AE90E (all manufactured by Nippon Aerosil Co., Ltd.), T400 (manufactured by Wacker Co., Ltd.), SFP-20M (manufactured by Denka Co., Ltd.).), Alu65 (manufactured by Nippon Aerosil Co., Ltd.), alumina particles such as AA-04 (manufactured by Sumitomo Chemical Co., Ltd.), boron nitride particles such as AP-170S (manufactured by Maruka), AEROXIDE (R) TiO2 P90 Titanium oxide particles such as (manufactured by Nippon Aerosil Co., Ltd.), alumina-doped silica particles such as MOX170 (manufactured by Nippon Aerosil Co., Ltd.), alumina hydrate particles manufactured by Sasol, and the like can be used.

The single crystal ceramic particles are preferably α-alumina single crystal particles having a crystal structure of α-alumina (αAl₂O₃). Commercially available α-alumina single crystal particles include AA-03, AA-04, AA-05, AA-07, and AA-1.5 of the Advanced Alumina (AA) series sold by Sumitomo Chemical Co., Ltd. can be used.

The content of the ceramic particles 22 in the insulation layer 20 is preferably in the range of 5% by volume or more and 60% by volume or less. If the content of the ceramic particles 22 is too small, the thermal conductivity of the insulation layer 20 may not be sufficiently improved. On the other hand, if the content of the ceramic particles 22 becomes too large, the content of the insulating resin 21 may decrease relatively, and the shape of the insulation layer 20 may not be stably maintained. In addition, the ceramic particles 22 tend to form excessively large aggregated particles, and the surface roughness Ra on the adhesion layer 30 side of the insulation layer 20 may increase. In order to reliably improve the thermal conductivity of the insulation layer 20, the content of the ceramic particles 22 is preferably 10% by volume or more. Further, in order to reliably improve the shape stability of the insulation layer 20 and reduce the surface roughness Ra, the content of the ceramic particles 22 is particularly preferably 50% by volume or less.

The film thickness of the insulation layer 20 is not particularly limited, but is preferably in the range of 1 µm or more and 200 µm or less, and particularly preferably in the range of 3 µm or more and 100 µm or less.

The adhesion layer 30 is a layer for improving the adhesion between the insulation layer 20 and the circuit layer 40. The adhesion layer 30 preferably has a low Young's modulus and high adhesion between the insulation layer 20 and the circuit layer 40. The Young's modulus of the adhesion layer 30 at 25°C is preferably 5 GPa or less, and particularly preferably 0.01 GPa or more and 3 GPa or less.

The adhesion layer 30 is preferably made of resin. As the resin, a silicone resin, an epoxy resin, a polyamideimide resin, or a polyimide resin can be used. The silicone resin includes a modified silicone resin into which various organic groups have been introduced. Examples of modified silicone resins include polyimide-modified silicone resins, polyester-modified silicone resins, urethane-modified silicone resins, acrylic-modified silicone resins, olefin-modified silicone resins, ether-modified silicone resins, alcohol-modified silicone resins, fluorine-modified silicone resins, amino-modified resins, mercapto-modified silicone resins, and carboxy-modified silicone resins. Examples of the epoxy resin include bisphenol A type epoxy resin, bisphenol F type epoxy resin, novolak type epoxy resin, aliphatic type epoxy resin, glycidylamine type epoxy resin and the like. One of these resins may be used alone, or two or more of these resins may be used in combination.

In the adhesion layer 30, thermally conductive fillers may be dispersed in order to improve the thermal conductivity. Ceramic particles can be used as the heat conductive fillers. Examples of ceramic particles include silica (silicon dioxide) particles, alumina (aluminum oxide) particles, boron nitride particles, titanium oxide particles, alumina-doped silica particles, alumina hydrate particles, and aluminum nitride particles. The content of the heat conductive fillers in the adhesion layer 30 is preferably in the range of 5% by volume or more and 60% by volume or less, and particularly preferably in the range of 10% by volume or more and 50% by volume or less.

The film thickness of the adhesion layer 30 is not particularly limited, but is preferably in the range of 0.1 µm or more and 20 µm or less, and particularly preferably in the range of 0.5 µm or more and 5 µm or less.

The circuit layer 40 has a yield stress in the range of 10 MPa or more and 150 MPa or less. If the yield stress is less than 10 MPa, the circuit layer 40 may become too soft and the workability in joining the electronic component 3 to the circuit layer 40 may decrease. On the other hand, when the yield stress exceeds 150 MPa, the circuit layer 40 is less likely to be deformed. The yield stress of the circuit layer 40 is preferably 110 MPa or less, more preferably 90 MPa or less.

The yield stress of the circuit layer 40 is a value measured according to the method described in JIS Z 2241 (metal material tensile test method). When measuring the yield stress, if a clear yield point cannot be confirmed, the yield stress is regarded as 0.2% proof stress.

As the average crystal grain size of the metal constituting the circuit layer 40 increases, the grain boundaries that suppress the slippage of dislocations decrease, so that the metal crystal grains tend to slip easily. Therefore, the circuit layer 40 becomes more easily deformed as the average crystal grain size increases. In order to make the circuit layer 40 more reliably deformed, the average crystal grain size of the circuit layer 40 is preferably 0.3 µm or more, more preferably 1.0 µm or more. It is particularly preferable that it is in the range of 20 µm or more and 1000 µm or less. When the crystal particle size is 0.3 µm or less, work hardening is likely to occur and the solder is likely to be cracked. If the crystal grain size exceeds 1000 µm, it is difficult to prepare such a sample and it is difficult to handle it. The average crystal grain size of the circuit layer 40 is a value measured by the EBSD method (electron backscatter diffraction analysis method).

Further, the metal constituting the circuit layer 40 has a high purity, and as the number of impurities decreases, defects tend to decrease, so that the metal crystal grains tend to slip easily with each other. Therefore, the circuit layer 40 becomes more easily deformed as the purity increases. In order to make the circuit layer 40 more reliably deformed, the purity of the circuit layer 40 is preferably 99% by mass or more, more preferably 99.99% by mass or more, and even more preferably 99.999% by mass. The purity of the circuit layer 40 is a value measured by the subtracting method. The subtracting method is a method in which the content of impurity elements in a sample is measured, and the value obtained by subtracting the content of impurity elements from 100% by mass is used as the purity of the sample. In the present embodiment, the content of the impurity element is measured by the ICP-MS method, and the impurity element to be measured is an element contained in the sample in an amount of 0.01 mass ppm or more.

As the material of the circuit layer 40, aluminum, copper, silver, gold, tin, iron, nickel, chromium, molybdenum, tungsten, palladium, titanium, zinc and alloys of these metals can be used. Among these metals, aluminum and copper are preferable, and aluminum is particularly preferable. The film thickness of the circuit layer 40 is in the range of 10 µm or more and 1000 µm or less, preferably in the range of 20 µm or more and 100 µm or less. If the film thickness of the circuit layer 40 becomes too thin, the thermal resistance may increase. On the other hand, if the film thickness of the circuit layer 40 becomes too thick, it may be difficult to form a circuit pattern by etching. Further, if the thickness of the circuit layer 40 becomes too thick, the thermal stress applied to the circuit layer 40 increases depending on the thermal expansion coefficient of each material constituting the module 1, and the insulation layer 20 becomes large during the cooling/heating cycles, making the circuit layer 40 to be easily peeled off.

Examples of the electronic component 3 mounted on the circuit layer 40 are not particularly limited, and examples thereof include a semiconductor element, a resistor, a capacitor, and a crystal oscillator. Examples of semiconductor elements include MOSFETs (Metal-oxide-semiconductor field effect transistor), IGBTs (Insulated Gate Bipolar Transistors), LSIs (Large Scale Integration), LEDs (Light emitting diodes), LED chip and LED-CSP (LED-Chip Size Package).

Next, a method for manufacturing the metal base substrate 2 of the present embodiment will be described.

The metal base substrate 2 of the present embodiment can be manufactured by, for example, a method in which the insulation layer 20 and the adhesion layer 30 are laminated in this order on the metal substrate 10, and then the circuit layer 40 is attached onto the adhesion layer 30.

As a method of forming the insulation layer 20 composed of the composition containing the insulating resin 21 and the ceramic particles 22 on the metal substrate 10, a coating method or an electrodeposition method can be used.

The coating method is a method of forming the insulation layer 20 on the metal substrate 10 by applying a coating solution including the insulating resin 21 and the ceramic particles 22 on the surface of the metal substrate 10 to form a coating layer; and by heating the coating layer to dry it. As a method of applying the coating solution for forming the insulation layer on the surface of the metal substrate 10, the spin coating method, the bar coating method, the knife coating method, the roll coating method, the blade coating method, the die coating method, the gravure coating method, the dip coating method, and the like can be used.

The electrodeposition method is a method of forming the insulation layer 20 on the metal substrate by immersing the metal substrate 10 and the electrode in an electrodeposition solution in which charged insulating resin particles and ceramic particles are dispersed and applying a DC voltage between the metal substrate 10 and the electrode to electro-deposit the insulating resin particles and the ceramic particles on the surface of the metal substrate 10 to form an electrodeposited layer; and then by heating the electrodeposited layer to dry it. The electrodeposition liquid can be prepared, for example, by adding a poor solvent for the insulating resin to an insulating resin solution containing ceramic particles to precipitate the insulating resin. For example, water can be used as the poor solvent for the insulating resin.

As a method of forming the adhesion layer 30 on the insulation layer 20, a coating method can be used. The adhesion layer 30 can be formed by applying a coating layer for forming adhesion layer including a resin for forming the adhesion layer, a solvent and heat conductive fillers (if necessary) on the surface of the insulation layer 20 to form a coating layer; and by heating the coating layer to dry it. As the method of applying the coating solution for forming the adhesion layer on the surface of the insulation layer 20, a spin coating method, a bar coating method, a knife coating method, a roll coating method, a blade coating method, a die coating method, a gravure coating method, a dip coating method and the like can be used.

The circuit layer 40 can be bonded by overlapping the circuit layer 40 on the adhesion layer 30 and then heating the circuit layer 40 while applying pressure. The heating is preferably performed in a non-oxidizing atmosphere (for example, in a nitrogen atmosphere or in a vacuum) so that the circuit layer 40 is not oxidized.

The circuit layer 40 is preferably adjusted so that the yield stress is within the range of 10 MPa or more and 150 MPa or less before being bonded to the adhesion layer 30. The yield stress of the circuit layer 40 can be adjusted by, for example, heat treatment. The yield strength of aluminum tends to decrease due to heat treatment. The heat treatment is preferably performed at a temperature of 200°C or higher and 500°C or lower. The heat treatment time varies depending on the heating temperature, but is usually in the range of 5 minutes or more and 500 minutes or less.

According to the metal base substrate 2 of the present embodiment having the above configuration, the circuit layer 40 has a film thickness in the range of 10 µm or more and 1000 µm or less, and a yield stress in the range of 10 MPa or more and 150 MPa or less. Because of these configurations, deformation of the circuit layer is facilitated. Therefore, when the cooling/heating cycles are applied, the stress applied to the solder can be relaxed by deformation of the circuit layer 40, so that the occurrence of cracking of the solder can be suppressed.

Further, in the metal base substrate 2 of the present embodiment, when the yield stress of the circuit layer 40 is 110 MPa or less, the circuit layer 40 is more easily deformed, so that the stress applied to the solder can be more reliably relaxed.

Further, in the metal base substrate 2 of the present embodiment, when the circuit layer 40 is made of aluminum, the effect of suppressing occurrence of cracking of the solder of the circuit layer 40 can be increased relatively easily a heat treatment.

Although the embodiments of the present invention have been described above, the present invention is not limited to this, and can be appropriately changed without departing from the technical idea of the invention.

For example, in the present embodiment, the configuration in which the adhesion layer 30 is provided between the insulation layer 20 and the circuit layer 40 has been described, but the present invention is not limited to this. If the insulation layer 20 alone can sufficiently secure the adhesion to the circuit layer 40, the adhesion layer 30 may not be provided. Further, the order of the insulation layer 20 and the adhesion layer 30 may be reversed. In this case, a metal based substrate can be produced by producing a laminated body in which the circuit layer 40, the insulation layer 20, and the adhesion layer 30 are laminated in this order; and by pressure bonding the adhesion layer 30 of the laminated body and the metal substrate 10 by thermo-compression bonding to form a metal base substrate.

### [Example]

Hereinafter, the action and effect of the present invention will be described with reference to Examples.

### [Example 1 of the present invention]

A separable flask having a capacity of 300 mL was charged with 4, 4'-diaminodiphenyl ether, and NMP (N-methyl-2-pyrrolidone). The amount of NMP was adjusted so that the concentration of the obtained polyamic acid was 40% by mass. After stirring at room temperature to completely dissolve 4, 4'-diaminodiphenyl ether, a predetermined amount of tetracarboxylic dianhydride was added little by little so that the internal temperature did not exceed 30°C. Then, stirring was continued for 16 hours under a nitrogen atmosphere to prepare a polyamic acid (polyimide precursor) solution.

Alumina particles (average particle diameter: 0.5 µm) were prepared as ceramic particles (thermally conductive filler). 1.0 g of the prepared alumina particles and 10 g of NMP were mixed and ultrasonically treated for 30 minutes to prepare an alumina particle dispersion.

The polyamic acid solution prepared as described above and the alumina particle dispersion were mixed so that the content of alumina particles in the solid substance (insulation layer) produced by heating was 30% by volume. Then, the mixture was diluted by NMP so that the concentration of the polyamic acid in the mixture was 5% by volume. Subsequently, the obtained mixture was dispersed by performing a dispersion treatment by repeating a high-pressure injection process at a pressure of 50 MPa 10 times using a star burst manufactured by Sugino Machine Limited; and an alumina particle-dispersed polyamic acid solution (coating solution for forming an insulation layer) was prepared.

A coating layer for forming the insulation layer was formed by applying a coating solution for forming an insulation layer on the surface of a copper substrate having a thickness of 0.3 mm and an area of 30 mm×20 mm by a bar coating method so that the thickness of the insulation layer generated by heating was 10 µm. Then, the copper substrate on which the coating layer for forming the insulation layer was formed was placed on a hot plate. The temperature was raised from room temperature to 60°C at 3°C/min. Then it was held at 60°C for 100 minutes. Then, the temperature was raised again to 120°C at 1°C/min. Then, the temperature was held at 120°C for 100 minutes to dry the coating layer for forming the insulation layer. Then, the copper substrate was heated at 250°C for 1 minute and at 400°C for 1 minute to prepare a copper substrate with an insulation layer.

Polyamideimide (elastic modulus: 2 GPa) and NMP were mixed at a mass ratio of 1: 6, and the polyamideimide was dissolved to prepare a polyamideimide solution (coating solution for forming an adhesion layer).

A coating layer for forming an adhesion layer was formed by applying a coating solution for forming an adhesion layer on the insulation layer of the copper substrate with an insulation layer by a spin coating method so that the thickness of the adhesion layer generated by heating was 1 µm. Then, a laminate, in which the copper substrate, the insulation layer and the adhesion layer were laminated in this order, was obtained by forming the adhesion layer on the insulation layer by heating the copper substrate with the insulation layer, the coating layer for forming the adhesion layer being formed thereon and drying the coating layer for forming the adhesion layer.

An aluminum foil (film thickness: 40 µm, size: 30 mm × 20 mm) was prepared. The aluminum foil had a purity of 99.999431% by mass, an average crystal grain size of 0.2 µm, and a yield stress (0.2% proof stress) of 132 MPa. The purity and average crystal grain size of the aluminum foil were measured by the following methods.

### (Purity measurement method)

The aluminum foil was dissolved with an acid, and the content of impurity elements in the obtained aluminum solution was measured by the ICP-MS method. From the obtained impurity element content, the total content of impurity elements in the aluminum foil was determined, and the value obtained by subtracting the total impurity element content from 100% by mass was taken as the purity of the aluminum foil. Na , Mg, Si, P, K, Ca, Ti, V, Cr, Mn, Fe, Co, Ni, Cu, Zn, Ga, Ge, Nb, Mo, Ru, Pd, Ag, an In, Sn , Sb, Ba, Hf, W, Pt, Au, Pb, and Bi were regarded as impurity elements.

### (Measuring method of average crystal grain size)

The average crystal grain size was measured by using the EBSD measurement device (FEI Co. Quanta FEG 450, EDAX / TSL Inc. OIM Data Collection) and analysis software (EDAX / TSL Inc. OIM Data Analysis ver.5.3) in a condition of: the acceleration voltage of the electron beam being 15kV; the measurement step being 0.5 µm; the measurement range being 84 µm × 56 µm; and the analysis range being 84 µm × 56 µm.

One surface of the prepared aluminum foil was immersed in a surface treatment liquid (Amalfa A-10201M manufactured by MEC Co., Ltd.) for 2 minutes. Next, the aluminum foil taken out from the surface treatment liquid was washed with water, immersed in a sulfuric acid aqueous solution having a concentration of 5% by mass for 20 seconds to neutralize, then washed again with water and dried to obtain a surface-treated aluminum foil. A surface-treated aluminum foil was laminated on the adhesion layer of the above-mentioned laminate so that the surface-treated surface was in contact with the adhesion layer, and then in vacuum while applying a pressure of 5 MPa using a carbon jig. The adhesion layer and the aluminum foil were bonded together by heating at a temperature of 215°C for 20 minutes. In this way, a metal base substrate in which a copper substrate, an insulation layer, an adhesion layer, and a circuit layer composed of an aluminum foil were laminated in this order was produced.

### [Examples 2 to 23 of the present invention, Comparative Examples 1 to 3]

Metal base substrates were produced as in Example 1 of the present invention, except for aluminum foils having values of the thickness, purity, average crystal grain size, and yield stress (0.2% proof stress) shown in Table 1 were used instead. In Examples 2 to 5, 7 to 23 of the present invention and Comparative Example 3, the average crystal grain size and the yield stress (0.2% proof stress) were adjusted by performing the heat treatment at a temperature of 300°C for the heat treatment time shown in Table 1 below.

### [Evaluation]

Sn-Ag-Cu solder (manufactured by Senju Metal Industry Co., Ltd .: M705) was applied onto the circuit layer of the metal base substrate to form a 2.5 mm × 2.5 mm solder layer with a thickness of 100 µm, and the solder layer was formed. A test piece was prepared by mounting a 2.5 mm × 2.5 mm square Si chip on the top. The prepared test piece was subjected to 3000 cooling/heating cycles in which one cycle was -40°C × 30 minutes to 150°C × 30 minutes. The test piece after the cooling/heating cycle was applied was embedded with resin, and the cross section was polished. The cross section of the solder layer of the test piece was observed, and the length (µm) of cracks generated in the solder layer was measured. The results are shown in Table 1 below.

**[Table 1]**

| | Circuit Layer | | | | | | Evaluation |
|---|---|---|---|---|---|---|---|
| | Type | Film thickness (µm) | Purity (mass%) | Heat treatment time [300°C] (min) | Average grain size (µm) | Yield stress (MPa) | Crack length of the solder layer after being subjected to cooling/heating cycles (µm) |
| Ex. 1 | Aluminum | 40 | 99.999431 | 0 | 0.2 | 132 | 0.22 |
| Ex. 2 | Aluminum | 40 | 99.999431 | 20 | 17.1 | 79 | 0.18 |
| Ex. 3 | Aluminum | 40 | 99.999431 | 60 | 33.8 | 48 | 0.08 |
| Ex. 4 | Aluminum | 40 | 99.999431 | 120 | 45.2 | 39 | 0.08 |
| Ex. 5 | Aluminum | 40 | 99.999431 | 240 | 54.5 | 30 | 0.07 |
| Ex. 6 | Aluminum | 40 | 99.992791 | 0 | 0.2 | 149 | 0.29 |
| Ex. 7 | Aluminum | 40 | 99.992791 | 10 | 9.0 | 83 | 0.12 |
| Ex. 8 | Aluminum | 40 | 99.992791 | 20 | 16.4 | 64 | 0.12 |
| Ex. 9 | Aluminum | 40 | 99.992791 | 30 | 20.7 | 52 | 0.05 |
| Ex. 10 | Aluminum | 40 | 99.992791 | 60 | 33.1 | 28 | 0.10 |
| Ex. 11 | Aluminum | 40 | 99.992791 | 120 | 42.5 | 22 | 0.02 |
| Ex. 12 | Aluminum | 40 | 99.992791 | 240 | 49.0 | 18 | 0.04 |
| Ex. 13 | Aluminum | 40 | 99.946129 | 20 | 12.8 | 108 | 0.19 |
| Ex. 14 | Aluminum | 40 | 99.946129 | 60 | 26.5 | 82 | 0.11 |
| Ex. 15 | Aluminum | 40 | 99.946129 | 120 | 34.9 | 75 | 0.11 |
| Ex. 16 | Aluminum | 40 | 99.946129 | 240 | 42.3 | 59 | 0.12 |
| Ex. 17 | Aluminum | 40 | 99.390201 | 20 | 11.4 | 150 | 0.27 |
| Ex. 18 | Aluminum | 40 | 99.390201 | 60 | 17.9 | 118 | 0.22 |
| Ex. 19 | Aluminum | 40 | 99.390201 | 120 | 25.4 | 105 | 0.17 |
| Ex. 20 | Aluminum | 40 | 99.390201 | 240 | 31.0 | 95 | 0.19 |
| Ex. 21 | Aluminum | 100 | 99.992791 | 10 | 8.7 | 83 | 0.11 |
| Ex. 22 | Aluminum | 500 | 99.992791 | 10 | 9.1 | 83 | 0.09 |
| Ex. 23 | Aluminum | 1000 | 99.992791 | 10 | 8.8 | 83 | 0.15 |
| C. Ex. 1 | Aluminum | 40 | 99.946129 | 0 | 0.2 | 172 | 0.35 |
| C. Ex. 2 | Aluminum | 40 | 99.390201 | 0 | 0.2 | 162 | 0.42 |
| C. Ex. 3 | Aluminum | 1200 | 99.992791 | 10 | 9.4 | 83 | The insulation layer and the circuit layer peeled off during cooling/heating cycles |

In the metal base substrates of Examples 1 to 23 of the present invention, in which the yield stress (0.2% proof stress) of the circuit layer (aluminum foil) was within the range of 10 MPa or more and 150 MPa or less, the lengths of cracks in the solder layers after being subjected to the cooling/heating cycles were shortened compared to the metal base substrates of Comparative Examples 1 to 2, in which the yield stress (0.2% proof stress) of the circuit layer exceeded 150 MPa. It is interpreted that this result is due to stress placed on the solder layer being relaxed by the deformation of the circuit layer in Examples 1 to 23 of the present invention after being subjected to the cooling/heating cycles. In particular, the lengths of cracks after being subjected to the cooling/heating cycles were significantly shortened in the extent of 0.2 µm or less in the metal base substrates of Examples 2 to 5, 7 to 16, 19 to 23 of the present invention, in which the yield stress (0.2% proof stress) of the circuit layer was 110 MPa or less. Further, in the metal base substrate of Comparative Example 3, in which the thickness of the circuit layer (aluminum foil) exceeded the range of the present invention, the insulation layer and the circuit layer were peeled off during the cooling/heating cycles.

### [Examples 24 to 26 of the present invention, Comparative Example 4]

Metal base substrates were produced as in Example 1 of the present invention, except that copper foils having values of the thickness, purity, average crystal grain size, and yield stress (0.2% proof stress) shown in Table 2 were used instead of aluminum foils. The average crystal grain size and the yield stress (0.2% proof stress) were adjusted by performing the heat treatment at a temperature of 300°C for the heat treatment time shown in Table 2 below in the copper foils. The purity of the copper foils was measured as in the case of the aluminum foil, except for Na, Mg, Si, Al, P, K, Ca, Ti, V, Cr, Mn, Fe, Co, Ni, Zn, Ga, Ge, Nb, Mo, Ru, Pd, Ag, In, Sn, Sb, Ba, Hf, W, Pt, Au, Pb, and Bi being regarded as impurity elements. The average crystal grain size of the copper foil was measured in the same manner as the average crystal grain size of the aluminum foil.

**[Table 2]**

| | Circuit Layer | | | | | | Evaluation |
|---|---|---|---|---|---|---|---|
| | Type | Film thickness (µm) | Purity (mass%) | Heat treatment time [300°C] (min) | Average grain size (µm) | Yield stress (MPa) | Crack length of the solder layer after being subjected to cooling/heating cycles (µm) |
| Ex. 24 | Copper | 40 | 99.910641 | 300 | 28.4 | 124 | 0.22 |
| Ex. 25 | Copper | 40 | 99.999929 | 300 | 52.8 | 95 | 0.11 |
| Ex. 26 | Copper | 40 | 99.999999 | 300 | 97.6 | 72 | 0.15 |
| C. Ex. 4 | Copper | 40 | 99.910641 | 10 | 0.5 | 185 | 0.38 |

Similarly, when the copper foil was used for the circuit layer, in the metal base substrate of Examples 24-26 of the present invention, in which the yield stress (0.2% proof stress) of the circuit layer (aluminum foil) was within the range of 10 MPa or more and 150 MPa or less, the lengths of cracks in the solder layers after being subjected to the cooling/heating cycles were shortened compared to the metal base substrates of Comparative Example 4, in which the yield stress (0.2% proof stress) of the circuit layer exceeded 150 MPa. In particular, the lengths of cracks after being subjected to the cooling/heating cycles were significantly shortened in the extent of 0.2 µm or less in the metal base substrates of Examples 25 to 26 of the present invention, in which the yield stress (0.2% proof stress) of the circuit layer was 110 MPa or less.

Based on above-described results, according to the example of the present invention, it is confirmed that a metal base substrate, in which the occurrence of cracking being suppressed even if it is subjected to a cooling/heating cycle in a state where an electronic component is mounted via a solder, can be provided.

### [Industrial applicability]

A metal base substrate, in which the occurrence of cracking being suppressed even if it is subjected to a cooling/heating cycle in a state where an electronic component is mounted via a solder, is provided.

### [Reference Signs List]

1: Module
2: Metal base substrate
3: Electronic component
4: Solder
10: Metal substrate
20: Insulation layer
21: Insulating resin
22: Ceramic particles
30: Adhesion layer
40: Circuit layer

## Claims

1. A metal base substrate comprising: a metal base; an insulation layer; and a circuit layer, the metal base, the insulation layer and the circuit layer being laminated in an order, wherein
the insulation layer includes a resin,
a film thickness of the circuit layer is in a range of 10 µm or more and 1000 µm or less, and
a yield stress of the circuit layer is in a range of 10 MPa or more and 150 MPa or less.

2. The metal bases substrate according to claim 1, wherein the yield stress of the circuit layer is 110 MPa or less.

3. The metal base substrate according to claim 1 or 2, wherein the circuit layer is made of aluminum.
